(19) Europäisches Patentamt
European Patent Office
Office européen des brevets

(11) **EP 2 521 175 B1**

(12) **FASCICULE DE BREVET EUROPEEN**

(45) Date de publication et mention de la délivrance du brevet:
**11.03.2020   Bulletin 2020/11**

(51) Int Cl.:
*H01L 25/07* (2006.01)        *H01L 23/498* (2006.01)
*H02M 7/00* (2006.01)        *H01L 23/373* (2006.01)

(21) Numéro de dépôt: **12166452.8**

(22) Date de dépôt: **02.05.2012**

(54) **Dispositif d'interconnexion électrique d'au moins un composant électronique avec une alimentation électrique comprenant des moyens de diminution d'une inductance de boucle entre une première et une deuxième borne**

Elektrische Anschlussvorrichtung zum Anschluss mindestens eines elektronischen Bauelements mit einer Stromversorgung, welche Anschlussvorrichtung Mittel zur Verringerung der Induktivität der Schleife zwischen einer ersten und einer zweiten Anschlussklemme umfasst

Electrical interconnection device of at least one electronic component with a power supply comprising means for reducing loop inductance between a first and a second terminal

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:   **03.05.2011   FR 1153767**

(43) Date de publication de la demande:
**07.11.2012   Bulletin 2012/45**

(73) Titulaire: **ALSTOM Transport Technologies**
**93400 Saint-Ouen (FR)**

(72) Inventeurs:
• **Dagdag, Selim**
  **65000 Tarbes (FR)**

• **Lasserre, Philippe**
  **64320 Ousse (FR)**

(74) Mandataire: **Lavoix**
**2, place d'Estienne d'Orves**
**75441 Paris Cedex 09 (FR)**

(56) Documents cités:
EP-A1- 0 588 094         EP-A1- 1 376 696
EP-A1- 2 019 429         EP-A2- 0 709 888
DE-A1- 10 333 315       DE-A1-102004 050 792
DE-A1-102008 000 825   JP-A- 2002 112 559

EP 2 521 175 B1

**EP 2 521 175 B1**

**Description**

La présente invention concerne un dispositif d'interconnexion électrique d'au moins un composant électronique avec une source d'alimentation électrique, du type comprenant un dispositif d'interconnexion électrique d'au moins un composant électronique avec une source d'alimentation électrique, du type comprenant :

- une première borne, une deuxième borne, et une boucle de circulation du courant entre la première borne et la deuxième borne,
- un substrat isolant comportant une surface plane supérieure et une surface plane inférieure sensiblement parallèles,
- une première couche électriquement conductrice disposée au contact de la surface supérieure du substrat isolant et comportant des pistes de circulation du courant électrique et des plages de connexion du ou de chaque composant électronique, la première couche conductrice formant un premier plan de circulation du courant,

la boucle de circulation comportant les pistes de circulation et présentant une inductance.

L'invention concerne également un système électronique propre à être connecté à une source d'alimentation, comprenant au moins un composant électronique et un tel dispositif d'interconnexion.

On connaît un dispositif d'interconnexion électrique du type précité. Le dispositif d'interconnexion électrique comprend un substrat isolant comportant une surface plane supérieure et une surface plane inférieure sensiblement parallèles, et une couche électriquement conductrice disposée sur la surface supérieure du substrat et présentant des pistes de circulation du courant électrique. Des première et deuxième bornes sont disposées sur des côtés opposés de la surface supérieure du substrat et connectées à la couche électriquement conductrice. Les pistes de circulation entre la première borne et la deuxième borne du dispositif d'interconnexion forment une boucle de circulation du courant. Le substrat est en céramique, et la tension supportée par le dispositif d'interconnexion est comprise entre 1200 V et 10000 V.

Toutefois, la boucle de circulation du courant entre la première borne et la deuxième borne d'un tel dispositif d'interconnexion électrique présente une inductance de valeur élevée, supérieure ou égale à 30 nH. Cette inductance parasite engendre des surtensions et des oscillations nécessitant de ralentir la commutation des composants, et empêchant alors d'utiliser des propriétés de commutation rapide de ces composants.

De l'état de la technique est également connu du document EP 1 376 696 A1.

Le but de l'invention est donc de proposer un dispositif d'interconnexion électrique permettant de diminuer la valeur de l'inductance de la boucle de circulation entre la première borne et la deuxième borne, afin d'autoriser une commutation plus rapide des composants.

A cet effet, l'invention a pour objet un dispositif d'interconnexion électrique du type précité, le dispositif d'interconnexion électrique selon la revendication 1 comprenant en outre des moyens de diminution de l'inductance de la boucle de circulation, les moyens de diminution comportant une deuxième couche électriquement conductrice disposée au contact de la surface inférieure du premier substrat isolant, un deuxième substrat isolant comportant une surface plane supérieure et une surface plane inférieure sensiblement parallèles, et une troisième couche électriquement conductrice disposée au contact de la surface supérieure du deuxième substrat isolant, la troisième couche conductrice étant fixée et connectée électriquement à la deuxième couche conductrice, les deuxième et troisième couches conductrices formant un deuxième plan de circulation du courant sensiblement parallèle au premier plan de circulation, la deuxième couche conductrice étant sensiblement la transposée de la première couche conductrice selon une direction perpendiculaire au premier plan, et une liaison électrique entre les deux plans de circulation, la première borne étant connectée au premier plan de circulation et la deuxième borne étant connectée au deuxième plan de circulation, de sorte que le courant électrique est propre à circuler de la première borne jusqu'à la deuxième borne dans les deux plans de circulation parallèles via la liaison électrique, le sens de circulation du courant dans le deuxième plan étant opposé à celui du courant dans le premier plan et comprenant en outre au moins une plaque de connexion du ou de chaque composant électronique avec la piste de circulation correspondante, la plaque de connexion comportant une surface plane supérieure, une surface plane inférieure sensiblement parallèles et une couche électriquement conductrice disposée au contact de la surface inférieure, ladite couche conductrice formant un plan additionnel de circulation du courant, le plan additionnel étant parallèle aux premier et deuxième plans de circulation, le sens de circulation du courant dans le plan additionnel étant identique à celui du courant dans le premier plan, la liaison électrique étant disposée extérieurement à chaque substrat isolant.

Suivant d'autres modes de réalisation, le dispositif d'interconnexion électrique comprend une ou plusieurs des caractéristiques suivantes, prises isolément ou suivant toutes les combinaisons techniquement possibles :

- le nombre de substrats isolants est égal à deux,
- le dispositif comprend une quatrième couche électriquement conductrice disposée au contact de la surface inférieure du deuxième substrat isolant, la quatrième couche conductrice étant propre à être fixée et connectée électriquement à une semelle de fixation reliée à une masse électrique,

2

- la première borne et la deuxième borne sont connectées du même côté du ou des substrats, à l'opposé de la liaison électrique,
- la liaison électrique est disposée extérieurement à le ou chaque substrat isolant,
- la liaison électrique est en forme d'une plaque métallique préformée, de préférence en cuivre,
- la première borne et la deuxième borne comportent chacune une platine s'étendant à l'écart du ou des substrats, et les platines des première et deuxième bornes sont en partie sensiblement parallèles l'une de l'autre, le dispositif comprenant en outre un isolant électrique agencé entre les platines,
- la première couche conductrice comprend des plages de connexion d'au moins deux composants électroniques, et les plages de connexion sont agencées de telle sorte que l'espacement entre deux composants électroniques est supérieur à trois millimètres, de préférence supérieur ou égal à cinq millimètres.

L'invention a également pour objet un système électronique propre à être connecté à une source d'alimentation électrique, du type comprenant au moins un composant électronique et un dispositif d'interconnexion du ou de chaque composant électronique avec la source d'alimentation électrique, le dispositif d'interconnexion étant tel que défini ci-dessus.

Ces caractéristiques et avantages de l'invention apparaîtront à la lecture de la description qui va suivre, donnée uniquement à titre d'exemple, et faite en référence aux dessins annexés, sur lesquels :

- la figure 1 est une vue schématique et en perspective d'un système électronique selon l'invention comprenant une pluralité de composants électroniques et un dispositif d'interconnexion des composants électroniques, et
- la figure 2 est une vue de côté du système électronique de la figure 1 avec des substrats additionnels de connexion électrique des composants.

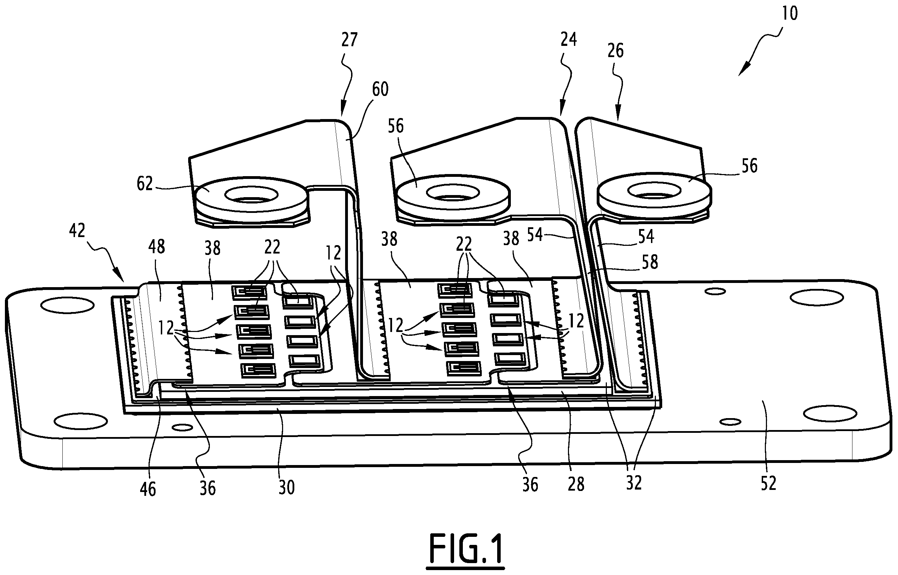

Sur la figure 1, un système électronique 10 propre à être connecté à une source d'alimentation électrique, non représentée, comprend une pluralité de composants électroniques 12 et un dispositif 14 d'interconnexion des composants électroniques avec la source d'alimentation électrique.

Le système électronique 10 est, par exemple, un convertisseur statique d'un courant en un autre courant. Dans l'exemple de réalisation de la figure 1, le système électronique 10 est un convertisseur d'un courant continu circulant sur un bus continu, non représenté, en un courant alternatif circulant sur un bus alternatif, non représenté. Le convertisseur continu-alternatif 10 est également appelé onduleur.

En variante, le système électronique est un convertisseur de courant alternatif en courant continu, également appelé redresseur. En variante encore, le système électronique est un convertisseur continu-alternatif bidirectionnel en courant et en tension, le courant étant propre à circuler depuis un bus continu vers un bus alternatif, mais également depuis le bus alternatif vers le bus continu.

En variante encore, le système électronique est un convertisseur continu-continu, ou encore un convertisseur alternatif-alternatif.

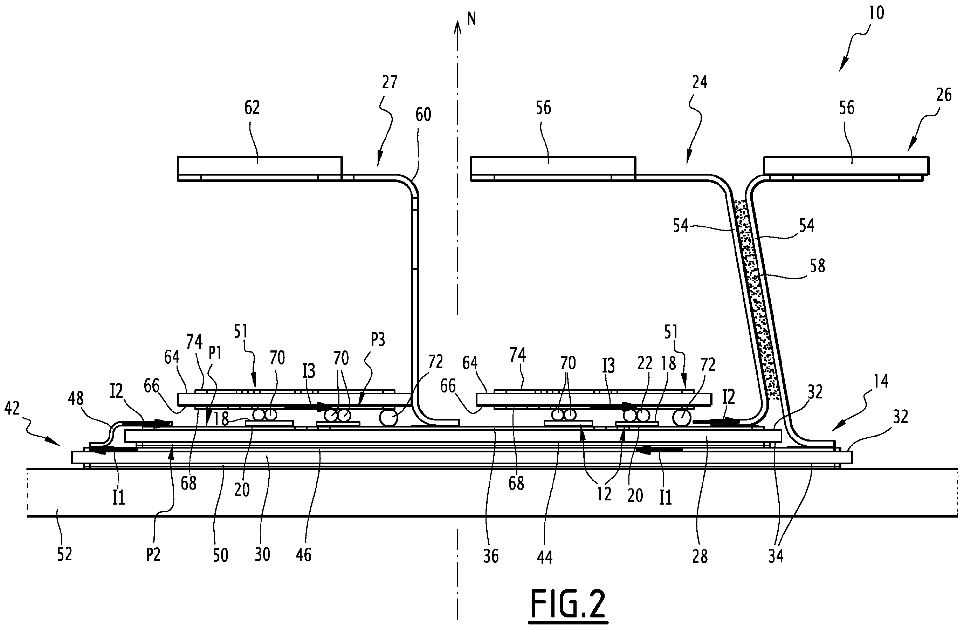

Chaque composant électronique 12 comprend, comme représenté sur la figure 2, une face supérieure 18 et une face inférieure 20 sensiblement parallèles. Chaque composant électronique 12 comprend des électrodes 22, visibles sur la figure 1, destinées à être reliées au dispositif d'interconnexion. Chaque composant électronique 12 comprend une unique électrode 22 sur sa face inférieure 20 et une ou plusieurs électrode(s) sur sa face supérieure 18.

Le composant électronique 12 est, par exemple, un transistor IGBT (de l'anglais Insulated Gâte Bipolar Transistor), et comporte alors deux électrodes 22 sur sa face supérieure 18. En complément, le composant électronique 12 est, par exemple, une diode, et comporte alors une seule électrode 22 sur sa face supérieure 18. Dans l'exemple de réalisation de la figure 1, le système électronique comprend dix transistors IGBT et huit diodes.

Le dispositif d'interconnexion 14 comprend une première borne 24 et une deuxième borne 26 propres à être reliées au bus continu. Le dispositif d'interconnexion 14 comprend une borne de phase 27 propre à être reliée au bus alternatif. Dans l'exemple de réalisation de la figure 1, le système électronique 10 est un onduleur, et la source d'alimentation est une source de tension continue reliée au bus continu.

Le dispositif d'interconnexion 14 comprend un premier substrat isolant 28 et un deuxième substrat isolant 30. Chaque substrat isolant 28, 30 comporte une surface plane supérieure 32 et une surface plane inférieure 34 sensiblement parallèles.

Le dispositif d'interconnexion électrique 14 comprend une première couche électriquement conductrice 36 disposée au contact de la surface supérieure du premier substrat isolant 28 et comportant des pistes 38 de circulation du courant électrique et des plages, non représentées, de connexion des composants électroniques. Les plages de connexion sont au contact de l'électrode des faces inférieures 20 des composants électroniques. La première couche conductrice 36 forme un premier plan P1 de circulation du courant, comme représenté sur la figure 2.

Le dispositif d'interconnexion 14 présente une boucle 42 de circulation du courant entre la première borne 24 et la deuxième borne 26, la boucle de circulation 42 comportant les pistes de circulation 38 et présentant une inductance L.

Le dispositif d'interconnexion électrique 14 comprend selon l'invention des moyens de diminution de l'inductance L de la boucle de circulation, les moyens de diminution comportant un deuxième plan P2 de circulation du courant parallèle au premier plan P1.

Dans l'exemple de réalisation des figures 1 et 2, les moyens de diminution comportent une deuxième couche électriquement conductrice 44 et une troisième couche électriquement conductrice 46 fixée et connectée électriquement à la deuxième couche conductrice 44, les deuxième et troisième couches conductrices 44, 46 formant le deuxième plan P2 de circulation du courant électrique.

Les moyens de diminution de l'inductance comprennent également une liaison électrique 48 entre les premier P1 et deuxième P2 plans de circulation. Dans l'exemple de réalisation des figures 1 et 2, la liaison électrique 48 est connectée entre la première couche conductrice 36 formant le premier plan de circulation et la troisième couche conductrice 46 du deuxième plan de circulation.

En complément, le dispositif d'interconnexion 14 comprend une quatrième couche électriquement conductrice 50 disposée au contact de la surface inférieure du deuxième substrat isolant 30, la quatrième couche conductrice 50 étant fixée et connectée électriquement à une semelle de fixation 52 reliée à une masse électrique, non représentée. La quatrième couche conductrice 50 est, par exemple, une couche de brasure avec la semelle de fixation 52.

Le dispositif d'interconnexion électrique 14 comprend deux plaques 51 de connexion de la ou des électrodes des faces supérieures 18 des composants électroniques avec les pistes de circulation 38 correspondantes, comme représenté sur la figure 2. En variante, les connexions de la ou des électrodes des faces supérieures 18 des composants électroniques aux pistes de circulation 38 correspondantes sont réalisées via des liaisons filaires métalliques (de l'anglais bonding).

La première borne 24 est connectée électriquement au premier plan P1 de circulation. Plus précisément, la première borne 24 est brasée à une piste de circulation 38 de la première couche conductrice.

La deuxième borne 26 est électriquement connectée au deuxième plan P2 de circulation. Dans l'exemple de réalisation des figures 1 et 2, la deuxième borne 26 est brasée à la troisième couche conductrice 46.

La première borne 24 et la deuxième borne 26 sont connectées du même côté des substrats 28, 30, à l'opposé de la liaison électrique 48.

La première borne 24 et la deuxième borne 26 comportent chacune une platine 54 s'étendant à l'écart des substrats 28, 30. Les première et deuxième bornes 24, 26 comportent chacune un anneau de connexion 56 solidaire de la platine 54 correspondante et destiné à permettre la connexion d'un câble électrique, non représenté, de liaison avec la source d'alimentation électrique. Les platines 54 des bornes d'entrée et de sortie sont en partie sensiblement parallèles l'une de l'autre.

En complément, le dispositif d'interconnexion 14 comprend un isolant électrique 58 agencé entre les platines 54 des bornes d'entrée et de sortie.

La borne de phase 27 comprend une platine 60 s'étendant à l'écart des substrats 28, 30 et un anneau de connexion 62 solidaire de la platine 60.

Les substrats isolants 28, 30 sont réalisés, par exemple, en nitrure d'aluminium (AlN), ou en oxyde d'aluminium ($Al_2O_3$), ou en nitrure de silicium ($Si_3N_4$), ou encore en alumine mono cristalline, également appelé saphir. Les substrats isolants 28, 30 sont de préférence en nitrure d'aluminium. Les substrats isolants 28, 30, 31 présentent, par exemple, une épaisseur de l'ordre du millimètre.

La deuxième couche conductrice 44 est disposée au contact de la surface inférieure du premier substrat isolant 28, et la troisième couche conductrice 46 est disposée au contact de la surface supérieure du deuxième substrat isolant 30.

La deuxième couche conductrice 44 est sensiblement la transposée de la première couche conductrice 36 selon une direction N perpendiculaire au premier plan P1.

La première couche conductrice 36, la deuxième couche conductrice 44, la troisième couche conductrice 46 et la quatrième couche conductrice 50 sont obtenues par métallisation du substrat isolant 28, 30 correspondant et présentent une épaisseur de quelques centaines de micromètres.

Les couches conductrices 36, 44, 46, 50 sont, par exemple, réalisées en cuivre ou en aluminium.

Les plages de connexion sont agencées de telle sorte que l'espace entre deux composants électroniques 12 est supérieur à 3 mm, de préférence supérieur ou égal à 5 mm.

La liaison électrique 48 est disposée extérieurement aux substrats isolants 28, 30. La liaison électrique 48 est en forme d'une plaque métallique préformée, de préférence en cuivre. Dans l'exemple de réalisation des figures 1 et 2, la liaison électrique 48 est brasée à la première couche conductrice 36 d'une part, et à la troisième couche conductrice 46 d'autre part.

Chaque plaque de connexion 51 comporte une surface plane supérieure 64, une surface plane inférieure 66 sensiblement parallèles, et une couche électriquement conductrice 68 disposée au contact de la surface inférieure. Chaque plaque de connexion 51 comporte des premières billes 70 de connexion entre l'électrode 22 correspondante d'un composant électronique et la couche conductrice 68. Chaque plaque de connexion 51 comporte des deuxièmes billes 72 de connexion entre la couche conductrice 68 et la piste de circulation 38 correspondante. Autrement dit, chaque première bille 70 est disposée entre la couche conductrice 68 de la plaque de connexion et l'électrode 22 correspondante d'un composant électronique, et chaque deuxième bille 72 est disposée entre la couche conductrice 68 et la piste de circulation 38 correspondante.

En complément, chaque plaque de connexion 51 comporte une couche électriquement conductrice 74 disposée au contact de la surface supérieure.

La semelle de fixation 52 est, par exemple, réalisée en un composite céramique-métal, par exemple un composite en aluminium avec des particules de carbure de silicium disposées dans l'aluminium.

L'isolant électrique 58 est, par exemple, une couche de matériau isolant souple disposée entre les platines 54 des bornes d'entrée et de sortie.

La couche conductrice 68 forme un plan additionnel P3 de circulation du courant, le plan additionnel P3 étant parallèle aux premier et deuxième plans de circulation P1, P2.

La couche conductrice 74 forme un plan de connexion électrique de moyens de commande des composants électroniques 12 respectifs, dans le cas où lesdits composants électroniques 12 sont commandables, tels que par exemple les transistors IGBT via leur électrode de grille. La couche conductrice 74 est alors également reliée aux électrodes de commande, telles que les électrodes de grille, des composants électroniques 12 commandables par l'intermédiaire de liaisons électriques non représentées.

Dans l'exemple de réalisation des figures 1 et 2, le nombre de substrats isolants 28, 30 est égal à 2.

Dans une variante qui ne fait pas partie de l'invention revendiquée, le dispositif d'interconnexion 14 comporte le seul premier substrat isolant 28 et les seules première 36 et deuxième 44 couches conductrices, la première couche conductrice 36 formant toujours le premier plan de circulation P1, et la deuxième couche conductrice 44 formant le deuxième plan de circulation P2 sensiblement parallèle au premier plan de circulation P1. La première borne 24 est connectée à la première couche conductrice 36, et la deuxième borne 26 est alors connectée à la deuxième couche conductrice 44. Selon cette variante, la liaison électrique 48 est connectée à la première couche conductrice 36 d'une part, et à la deuxième couche conductrice 44 d'autre part. La semelle de fixation 52 est une semelle électriquement isolante, et la deuxième couche conductrice 44 est électriquement isolée de la masse électrique.

Le fonctionnement du système électronique selon l'invention va désormais être expliqué à l'aide de la figure 2.

La conversion de la tension continue en une tension alternative par l'onduleur 10 comporte alternativement une première phase au cours de laquelle la tension de la borne positive, par exemple la deuxième borne 26, circule jusqu'à la borne de phase 27, et une deuxième phase au cours de laquelle la tension de la borne négative, par exemple la première borne 24, circule jusqu'à la borne de phase 27. La tension délivrée à la borne de phase est ainsi une tension alternative. La première et la deuxième phase sont des phases de conduction du courant d'une borne 24, 26 à la borne de phase 27.

La conversion de la tension continue en une tension alternative comporte également une phase de commutation entre deux phases de conduction successives. Pendant une première phase de commutation entre la première phase de conduction et la deuxième phase de conduction, le courant circule de la deuxième borne 26 jusqu'à la première borne 24, comme représenté sur la figure 2 avec les flèches I1 à I3. Inversement, pendant une deuxième phase de commutation entre la deuxième phase de conduction et la première phase de conduction, le courant circule de la première borne 24 jusqu'à la deuxième borne 26.

Durant la première phase de commutation, le courant circule depuis la deuxième borne 26 jusqu'à la liaison électrique 48 dans le deuxième plan de circulation P2 selon un premier sens de circulation (Flèche I1). Le courant électrique circule ensuite depuis la liaison électrique 48 jusqu'à la première borne 24 dans le premier plan de circulation P1 selon un deuxième sens de circulation (Flèche I2) opposé au premier sens de circulation, ainsi que dans le plan additionnel P3 des plaques de connexion. Le sens de circulation (Flèche I3) du courant dans le plan additionnel est identique à celui du courant dans le premier plan (Flèche I2).

Autrement dit, le courant électrique circule durant la première phase de commutation de la deuxième borne 26 jusqu'à la première borne 24 dans les deux plans de circulation P2, P1 parallèles via la liaison électrique 48, et le sens de circulation du courant dans le deuxième plan P2 est opposé à celui du courant dans le premier plan P1 créant ainsi une mutuelle inductance M entre les deux plans de circulation P1, P2.

Inversement, par analogie, le courant électrique circule durant la deuxième phase de commutation de la première borne 24 jusqu'à la deuxième borne 26 dans les deux plans de circulation P1, P2 parallèles via la liaison électrique 48, et le sens de circulation du courant dans le deuxième plan P2 est également opposé à celui du courant dans le premier plan P1 créant également la mutuelle inductance M entre les deux plans de circulation P1, P2.

L'inductance L de la boucle de circulation 42 présente alors une valeur plus faible que celle de la boucle de circulation du courant du dispositif d'interconnexion de l'état de la technique, puisque la mutuelle inductance M entre les deux plans de circulation P1, P2 diminue l'inductance L de la boucle de circulation 42.

Plus précisément, l'inductance L de la boucle de circulation du dispositif d'interconnexion selon l'invention, vérifie l'équation suivante, dans le cas où la ou des électrodes des faces supérieures 18 des composants électroniques sont reliées électriquement aux pistes de circulation 38 correspondantes par les liaisons filaires métalliques (de l'anglais

bonding) :

$$L = L1 + L2 - 2xM \qquad\qquad (I)$$

où L1 représente l'inductance du premier plan P1 et L2 représente l'inductance du deuxième plan P2.

En comparaison, l'inductance Lini de la boucle de circulation du dispositif d'interconnexion de l'état de la technique vérifie l'équation suivante :

Lini = L1

L'inductance L de la boucle de circulation du dispositif d'interconnexion 14 selon l'invention est alors inférieure à 10 nH, par exemple égale à 8 nH, et est ainsi nettement inférieure à celle du dispositif d'interconnexion de l'état de la technique, de valeur supérieure à 30 nH dans les mêmes conditions de courant et de tension.

En outre, l'agencement des platines 54 des bornes d'entrée et de sortie, en partie parallèles l'une de l'autre, permet également de créer une mutuelle inductance.

L'espacement supérieur à trois millimètres entre les composants électroniques 12 permet de diminuer la résistance thermique due aux composants électroniques, et ainsi de compenser la légère augmentation de résistance thermique due à la présence du deuxième substrat isolant 30, de sorte que la résistance thermique du système électronique selon l'invention est sensiblement équivalente à celle du système électronique de l'état de la technique.

On conçoit ainsi que le dispositif d'interconnexion électrique selon l'invention permet de diminuer la valeur de l'inductance parasite de la boucle de circulation du courant entre la première borne et la deuxième borne. Cela autorise alors une commutation plus rapide des composants électroniques, la diminution de l'inductance parasite de boucle entraînant une réduction des surtensions et des oscillations dans le système électronique.

## Revendications

1. Dispositif (14) d'interconnexion électrique d'au moins un composant électronique (12) avec une source d'alimentation électrique, du type comprenant, en fonctionnement,

   - une première borne (24), une deuxième borne (26), et une boucle (42) de circulation du courant entre la première borne (24) et la deuxième borne (26),
   - un premier substrat isolant (28) comportant une surface plane supérieure (32) et une surface plane inférieure (34) sensiblement parallèles,
   - une première couche électriquement conductrice (36) disposée au contact de la surface supérieure (32) du premier substrat isolant et comportant des pistes (38) de circulation du courant électrique et des plages (40) de connexion du ou de chaque composant électronique (12), la première couche conductrice (36) formant un premier plan (P1) de circulation du courant,
   la boucle de circulation (42) comportant les pistes de circulation (38) et présentant une inductance (L), le dispositif d'interconnexion électrique comprenant des moyens de diminution de l'inductance (L) de la boucle de circulation, les moyens de diminution comportant une deuxième couche électriquement conductrice (44) disposée au contact de la surface inférieure (34) du premier substrat isolant (28), un deuxième substrat isolant (30) comportant une surface plane supérieure (32) et une surface plane inférieure (34) sensiblement parallèles, et une troisième couche électriquement conductrice (46) disposée au contact de la surface supérieure (34) du deuxième substrat isolant (30), la troisième couche conductrice (46) étant fixée et connectée électriquement à la deuxième couche conductrice (44), les deuxième et troisième couches conductrices (44, 46) formant un deuxième plan (P2) de circulation du courant sensiblement parallèle au premier plan de circulation (P1), la deuxième couche conductrice (44) étant sensiblement la transposée de la première couche conductrice (36) selon une direction perpendiculaire au premier plan (P1), et une liaison électrique (48) entre les deux plans de circulation (P1, P2), la première borne (24) étant connectée au premier plan de circulation (P1) et la deuxième borne (26) étant connectée au deuxième plan de circulation (P2), de sorte que le courant électrique est propre à circuler de la première borne (24) jusqu'à la deuxième borne (26) dans les deux plans de circulation parallèles (P1, P2) via la liaison électrique (48), le sens de circulation (I2) du courant dans le deuxième plan étant opposé à celui (I1) du courant dans le premier plan, et comprenant en outre au moins une plaque (51) de connexion du ou de chaque composant électronique (12) avec la piste de circulation (38) correspondante, la plaque de connexion (51) comportant une surface plane supérieure (64), une surface plane inférieure (66) sensiblement parallèles et une couche électriquement conductrice (68) disposée au contact de la surface inférieure (66), ladite couche conductrice (68) formant un plan additionnel (P3) de circulation du courant, le plan additionnel

(P3) étant parallèle aux premier et deuxième plans de circulation (P1, P2), le sens de circulation (I3) du courant dans le plan additionnel étant identique à celui (I1) du courant dans le premier plan, la liaison électrique (48) étant disposée extérieurement à chaque substrat isolant (28, 30).

2. Dispositif (14) selon la revendication 1, dans lequel le nombre de substrats isolants (28, 30) est égal à deux.

3. Dispositif (14) selon la revendication 1 ou 2, comprenant une quatrième couche électriquement conductrice (50) disposée au contact de la surface inférieure (34) du deuxième substrat isolant (30), la quatrième couche conductrice (50) étant propre à être fixée et connectée électriquement à une semelle de fixation (52) reliée à une masse électrique.

4. Dispositif (14) selon l'une des revendications précédentes, dans lequel la première borne (24) et la deuxième borne (26) sont connectées du même côté du ou des substrats (28, 30), à l'opposé de la liaison électrique (48).

5. Dispositif (14) selon l'une quelconque des revendications précédentes, dans lequel la liaison électrique (48) est en forme d'une plaque métallique préformée, de préférence en cuivre.

6. Dispositif (14) selon l'une quelconque des revendications précédentes, dans lequel la première borne (24) et la deuxième borne (26) comportent chacune une platine (54) s'étendant à l'écart du ou des substrats, et dans lequel les platines (54) des première et deuxième bornes sont en partie sensiblement parallèles l'une de l'autre, le dispositif (14) comprenant en outre un isolant électrique (58) agencé entre les platines (54).

7. Dispositif (14) d'interconnexion d'au moins deux composants électroniques (12) avec la source d'alimentation électrique, selon l'une quelconque des revendications précédentes, la première couche conductrice (36) comprenant des plages de connexion des au moins deux composants électroniques, dans lequel les plages de connexion sont agencées de telle sorte que l'espacement entre deux composants électroniques (12) est supérieur à trois millimètres, de préférence supérieur ou égal à cinq millimètres.

8. Système électronique (10) propre à être connecté à une source d'alimentation électrique, du type comprenant au moins un composant électronique (12), et un dispositif (14) d'interconnexion du ou de chaque composant électronique (12) avec la source d'alimentation électrique,
**caractérisé en ce que** le dispositif d'interconnexion (14) est conforme à l'une quelconque des revendications précédentes.

**Patentansprüche**

1. Vorrichtung (14) zur elektrischen Verbindung wenigstens einer elektronischen Komponente (12) mit einer elektrischen Versorgungsquelle, des Typs, aufweisend, im Betrieb,

- einen ersten Pol (24), einen zweiten Pol (26) und eine Schleife (42) zum Leiten des Stroms zwischen dem ersten Pol (24) und dem zweiten Pol (26),
- ein erstes isolierendes Substrat (28), das eine obere ebene Fläche (32) und eine untere ebene Fläche (34) aufweist, die im Wesentlichen parallel sind,
- eine erste elektrisch leitende Schicht (36), die im Kontakt mit der oberen Fläche (32) des ersten isolierenden Substrats angeordnet ist und die Bahnen (38) zum Leiten des elektrischen Stroms (12) und Bereiche (40) zur Verbindung der oder jeder elektronischen Komponente (12) aufweist, wobei die erste leitende Schicht (36) eine erste Ebene (P1) zur Leitung des Stroms bildet,
wobei die Schleife zum Leiten (42) die Bahnen zum Leiten (38) aufweist und eine Induktivität (L) hat,
wobei die Vorrichtung zur elektrischen Verbindung aufweist Mittel zur Verringerung der Induktivität (L) der Schleife zum Leiten, wobei die Mittel zur Verringerung aufweisen eine zweite elektrisch leitende Schicht (44), die im Kontakt mit der unteren Fläche (34) des ersten isolierenden Substrats (28) angeordnet ist, ein zweites isolierendes Substrat (30), das eine obere ebene Fläche (32) und eine untere ebene Fläche (34) aufweist, die im Wesentlichen parallel sind, und eine dritte elektrisch leitende Schicht (46), die im Kontakt mit der oberen Fläche (34) des zweiten isolierenden Substrats (30) angeordnet ist, wobei die dritte leitende Schicht (46) an der zweiten leitenden Schicht (44) fixiert und mit dieser elektrisch verbunden ist, wobei die zweite und die dritte leitende Schicht (44, 46) eine zweite Ebene (P2) zum Leiten des Stroms bilden, die im Wesentlichen parallel zur ersten Ebene zum Leiten (P1) ist, wobei die zweite leitende Schicht (44) im Wesentlichen die Transponierte der ersten leitenden Schicht (36) entlang einer Richtung senkrecht zur ersten Ebene (P1) ist, und eine elektrischen Verbindung (48) zwischen den beiden Ebenen zum Leiten (P1, P2), wobei der erste Pol (24) mit der ersten Ebene zum Leiten (P1) verbunden ist und der zweite Pol (26) mit der zweiten Ebene zum Leiten (P2) verbunden ist, sodass der elektrische Strom imstande ist, vom ersten Pol (24) aus zum zweiten Pol (26) zu fließen in den beiden parallelen Ebenen zum Leiten (P1, P2) über die elektrische Verbindung (48), wobei die Fließrichtung (I2) des Stroms in der zweiten Ebene entgegengesetzt zu jener (I1) des Stroms in der ersten Ebene ist, und ferner aufweist wenigstens eine Platte (51) zur Verbindung der oder jeder elektronischen Komponente (12) mit der korrespondierenden Bahn zum Leiten (38), wobei die Platte zum Verbinden (51) eine obere ebene Fläche (64), eine untere ebene Fläche (66), die im Wesentlichen parallel sind, und eine elektrisch leitenden Schicht (68) aufweist, die im Kontakt mit der oberen Fläche (66) angeordnet ist, wobei die leitende Schicht (68) eine zusätzliche Ebene (P3) zum Leiten des Stroms bildet, wobei die zusätzliche Ebene (P3) parallel zu der ersten und der zweiten Bahn zum Leiten (P1, P2) ist, wobei die Fließrichtung (I3) des Stroms in der zusätzlichen Ebene identisch ist zu jener (I1) des Stroms in der ersten Ebene, wobei die elektrische Verbindung (48) außen an jedem isolierenden Substrat (28, 30) angeordnet ist.

2. Vorrichtung (14) gemäß Anspruch 1, wobei Anzahl an isolierenden Substraten (28, 30) gleich zwei ist.

3. Vorrichtung (14) gemäß Anspruch 1 oder 2, aufweisend eine vierte elektrisch leitende Schicht (50), die im Kontakt mit der unteren Fläche (34) des zweiten isolierenden Substrats (30) angeordnet ist, wobei die vierte leitende Schicht (50) imstande ist, befestigt zu sein an und elektrisch verbunden zu sein mit einer Befestigungssohle (52), die mit einer elektrischen Masse verbunden ist.

4. Vorrichtung (14) gemäß einem der vorhergehenden Ansprüche, wobei der erste Pol (24) und der zweite Pol (26) auf der gleichen Seite des oder der Substrate (28, 30) entgegengesetzt zu der elektrischen Verbindung (48) angeschlossen sind.

5. Vorrichtung (14) gemäß irgendeinem der vorhergehenden Ansprüche, wobei die elektrische Verbindung (48) in Form einer vorgeformten Metallplatte ist, bevorzugt aus Kupfer.

6. Vorrichtung (14) gemäß irgendeinem der vorhergehenden Ansprüche, wobei der erste Pol (24) und der zweite Pol (26) jeweils eine Platte (54) aufweisen, die sich im Abstand von dem oder den Substraten erstreckt, und wobei die Platten (54) des ersten und des zweiten Pols teilweise im Wesentlichen parallel zueinander sind, wobei die Vorrichtung (14) ferner einen elektrischen Isolator (58) aufweist, der zwischen den Platten (54) angeordnet ist.

7. Vorrichtung (14) zur Verbindung wenigstens zweier elektronischen Komponenten (12) mit der elektrischen Versorgungsquelle, gemäß irgendeinem der vorhergehenden Ansprüche, wobei die erste leitende Schicht (36) aufweist Bereiche zur Verbindung der wenigstens zwei elektronischen Komponenten, wobei die Bereiche zur Verbindung derart angeordnet sind, dass der Raum zwischen zwei elektronischen Komponenten (12) größer als drei Millimeter ist, bevorzugt größer oder gleich fünf Millimeter ist.

8. Elektronisches System (10), das imstande ist, mit einer elektrischen Versorgungsquelle verbunden zu sein, des Typs, der aufweist wenigstens eine elektronische Komponente (12) und eine Vorrichtung (14) zur Verbindung der oder jeder elektronischen Komponente (12) mit der elektrischen Versorgungsquelle, **dadurch gekennzeichnet, dass** die Vorrichtung zur Verbindung (14) einer gemäß irgendeinem der vorausgehenden Ansprüche entspricht.

**Claims**

1. A device (14) for electrically interconnecting at least one electronic component (12) with an electrical power supply, of the type comprising, during operation:

   - a first terminal (24), a second terminal (26), and a current conducting loop (42) between the first terminal (24) and the second terminal (26),
   - a first insulating substrate (28) comprising a top plane surface (32) and a bottom plane surface (34) which are substantially parallel,
   - a first electrically conductive layer (36) arranged in contact with the top surface (32) of the first insulating substrate and including electrical current tracks (38) and pads (40) for connecting the or each electronic component (12), the first conductive layer (36) forming a first current conducting plane (P1),
   the conducting loop (42) including the tracks (38) and having an inductance (L),

the device for electrically interconnecting comprising

means for reducing the inductance (L) of the conducting loop, the reduction means including a second electrically conductive layer (44) arranged in contact with the bottom surface (34) of the first insulating substrate (28), a second insulating substrate (30) comprising a top plane surface (32) and a bottom plane surface (34) which are substantially parallel, and a third electrically conductive layer (46) arranged in contact with the top surface (34) of the second insulating substrate (30), the third conductive layer (46) being fastened and electrically connected to the second conductive layer (44), the second and third conductive layers (44, 46) forming a second current conducting plane (P2) substantially parallel to the first conducting plane (P1), the second conductive layer (44) substantially being the transpose of the first conductive layer (36) in a direction normal to the first plane (P1), and an electrical link (48) between the two conducting planes (P1, P2), the first terminal (24) being connected to the first conducting plane (P1), and the second terminal (26) being connected to the second conducting plane (P2) so that the electrical current is capable of flowing from the first terminal (24) to the second terminal (26) in the two parallel conducting planes (P1, P2) through the electrical link (48), the flow direction (12) of the current in the second plane being opposite to the flow direction (11) of the current in the first plane, and further comprising at least one plate (51) for connecting the or each electronic component (12) to the corresponding track (38), the connecting plate (51) comprising a top plane surface (64), a bottom plane surface (66) substantially parallel, and an electrically conductive layer (68) arranged in contact with the bottom surface (66), said conductive layer (68) forming an additional current conducting plane (P3), the additional plane (P3) being parallel to the first and second conducting planes (P1, P2), the flow direction (I3) of the current in the additional plane being the same as the flow direction (I1) of the current in the first plane, the electrical link (48) being arranged externally to the or each insulating substrate (28, 30).

2. The device (14) according to claim 1, wherein the number of insulating substrates (28, 30) is two.

3. The device (14) according to claim 1 or 2, comprising a fourth electrically conductive layer (50) arranged in contact with the bottom surface (34) of the second insulating substrate (30), the fourth conductive layer (50) being capable of being fastened and electrically connected to a fastening base (52) connected to ground.

4. The device (14) according to any of the preceding claims, wherein the first terminal (24) and the second terminal (26) are connected on the same side of the substrate(s) (28, 30), opposite the electrical link (48).

5. The device (14) according to any of the preceding claims, wherein the electrical link (48) comes in the form of a preformed metal plate, preferably made of copper.

6. The device (14) according to any of the preceding claims, wherein the first terminal (24) and the second terminal (26) respectively include a bearing plate (54) extending separately from the substrate(s), and wherein the bearing plates (54) of the first and second terminals are in part substantially parallel to one another, the device (14) further comprising an electrical insulator (58) arranged between the bearing plates (54).

7. The device (14) for interconnecting at least two electronic components (12) with the electrical power supply according to any of the preceding claims, the first conductive layer (36) comprising pads for connecting the at least two electronic components, wherein the pads are arranged so that the spacing between two electronic components (12) is greater than three millimeters, preferably greater than or equal to five millimeters.

8. An electronic system (10) capable of being connected to an electrical power supply, of the type comprising at least one electronic component (12), and a device (14) interconnecting the or each electronic component (12) with the electrical power supply,
   **characterized in that** the interconnecting device (14) is according to any of the preceding claims.

EP 2 521 175 B1

FIG.1

FIG.2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1376696 A1